Europäisches Patentamt

European Patent Office

Office européen des brevets

(19)

(11) Publication number: **0 144 374**
**B1**

# (12) EUROPEAN PATENT SPECIFICATION

(45) Date of publication of patent specification: **10.08.88**

(51) Int. Cl.⁴: **H 05 K 13/04**

(21) Application number: **84902031.8**

(22) Date of filing: **11.05.84**

(86) International application number:
**PCT/GB84/00161**

(87) International publication number:
**WO 84/04867 06.12.84 Gazette 84/28**

(54) COMPONENT LEG BENDING DEVICE.

(30) Priority: **26.05.83 GB 8314628**

(43) Date of publication of application:
**19.06.85 Bulletin 85/25**

(45) Publication of the grant of the patent:
**10.08.88 Bulletin 88/32**

(84) Designated Contracting States:
**AT BE CH DE FR GB LI LU NL SE**

(56) References cited:
**US-A-2 758 303**
**US-A-4 151 637**
**US-A-4 288 914**
**US-A-4 309 808**

(73) Proprietor: **AMBOTECH LIMITED**
**Icen House Icen Way**
**Dorchester Dorset DT1 1ES (GB)**

(72) Inventor: **MASKENS, Geoffrey, David**
**4 The Plocks Blandford**
**Dorset DT11 7AA (GB)**

(74) Representative: **Meddle, Alan Leonard et al**
**FORRESTER & BOEHMERT Widenmayerstrasse 4/I**
**D-8000 München 22 (DE)**

Courier Press, Leamington Spa, England.

## Description

This invention relates to a device for bending a leg of a component inserted on a printed circuit board.

During the assembly of electronic components onto printed circuit boards, it is often necessary to hold a component onto the board by bending the leads or legs which protrude through the board in opposite directions prior to soldering or otherwise securing the component in place. Where the insertion is carried out automatically by machine, this is normally achieved by a simple mechanical device which is limited to bending the legs or leads only in (or alternatively out) with respect to the component and is not readily adjustable in different directions of bend, or lead pitch.

Automatic lead bending devices have, in the past, suffered due to restrictions on the range limit of the direction in which the leads of a component inserted into a circuit board may be bent and, also, on the adaptability of a lead bending device for use with components of variable dimension.

There is disclosed in U.S. Patent No. 4,288,914, a device for cutting and clinching electrical component leads. In this device, the clinching of the leads of a component is carried out in a direction normal to the axis of the component and each one of the pair of leads is bent to an angle of 180° with respect to the other. The component leads are bent by laterally offset knives. The angularity of the clinching path of the knives are determined by the selected orientation of a pair of parallel guideways by the rotation of a circular rotable disc. Using the above device, each component lead may be bent within a 90° sectional range limit surrounding a component lead.

A further clinching device is disclosed in U.S. Patent No. 2,758,303 which provides a mechanism allowing the leads of a component to be bent in any desired orientation. An anvil comprises a pair of individually depressible terminals respectively mounted in order that each is engaged by a component lead inserted through a chassis or circuit board. The anvil further comprises an electric circuit arranged to be closed when the depressible terminals have been engaged by the inserted component leads. The terminals are adapted in order to ensure clinching of each lead can be effected in any desired radial direction. However, if both leads fail to be inserted, or if either lead of a component fails to be inserted and hence to engage and depress the anvil terminals, the electric circuit cannot be closed and therefore any protruding component leads will not be bent. In this device, the clinching terminals must be of a similar distance apart as the component leads themselves in order that upon insertion, a component leads will depress the terminals in order to complete the electric circuit.

The present invention aims to provide a device capable of bending the leads of a component in any desired direction and capable of being used with any size of component.

Accordingly, the present invention provides apparatus for bending the legs of a component inserted into a printed circuit board, the apparatus comprising a plurality of bending devices, each bending device comprising a member rotatably mounted to a frame of the device for engaging a respective leg of a component, means for rotating the engaging member to a selected one of a plurality of orientations and means for displacing the engaging member in the selected orientation to bend the respective component leg in a selected direction, the means for displacing engaging member comprising a slider which is connected to the respective engaging member and which is movable by a respective hydraulically actuated device to effect translation movement of the engaging member.

For a better understanding of the present invention, and to show how the same may be put into effect, reference will now be made, by way of example, to the accompanying drawings, in which:

Figures 1 and 2 illustrate diagrammatically the method by which a component lead is inserted into a printed circuit board;

Figure 3 illustrates in plan view a device embodying the invention;

Figure 3A is a view, partly in section, taken along the direction of arrow A in Figure 3 of a drum of the device; and

Figure 4 illustrates apparatus comprising two of the devices shown in Figure 3.

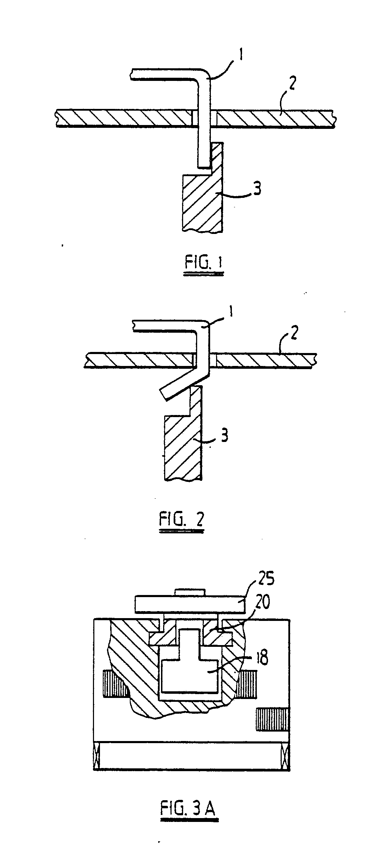

Referring now to the drawings, Figure 1 shows a component lead or leg 1 protruding through a printed circuit board 2 onto an anvil 3 of a bending device which is constrained to move the anvil 3 in only one direction, that is, from right to left in the drawings. Figure 2 shows how movement of the anvil 3 causes the components lead 1 to bend.

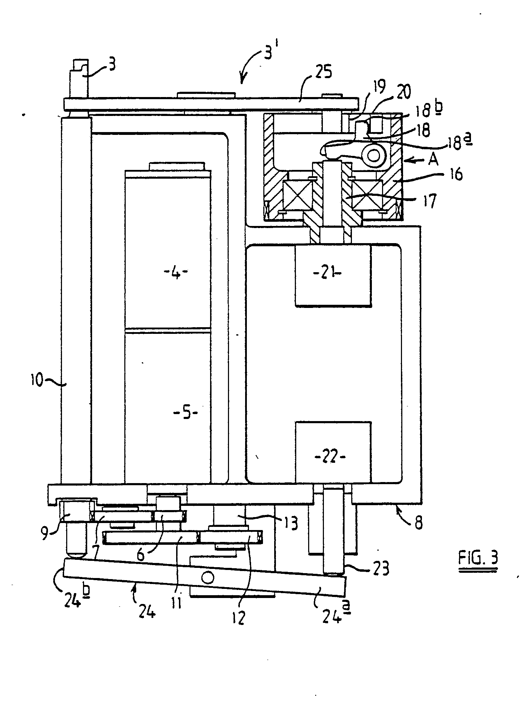

Figure 3 illustrates diagrammatically a bending device embodying the invention.

The device 3' comprises a motor 4 connected to a gearbox 5. The output shaft of the gearbox 5 carries a first gear 6 which meshes with a second gear 7 rotatably mounted to a frame 8 of the device. The second gear 7 meshes with a third gear 9 fixedly secured to one end of a rod 10 freely rotatably mounted to the frame 8. The other end of the rod 10 carries the anvil 3.

A fourth gear 11 is also secured to the gearbox output shaft and meshes with a fifth gear 12 carried on one end of a shaft 13 rotatably mounted in the frame 8. The other end of the shaft 13 is connected by gearing to a drum 16 so that transmission is provided from the motor 4 to the anvil 3 and the drum 16.

A drum support shaft 17 extends into the drum 16 and is geared thereto. One arm 18a of a bifurcate rocking member 18 rests on the free end of the drum support shaft. The other arm 18b of the rocking member 18 which is pivotally mounted to the interior of the drum is arranged to engage in an aperture 19 formed in a slider 20 disposed in the drum so as to be slidable in a radial direction of the drum. The slider 20 is connected via a rod 25 to the anvil 3.

Figure 3a is a view along the arrow A of Figure 3, partly in section showing the mounting of the slider.

The drum support shaft 17 forms the piston of an air piston and cylinder arrangement, the air cylinder 21 of which is actuable to raise or lower the drum support shaft so as to pivot the rocking member 18 and cause the slider 20 to move back and forth.

A second air piston and cylinder arrangement has a cylinder 22 and piston rod 23 the free end of which rests on one end 24a of a rod 24 pivotally mounted to part of the frame. The other end 24b of the rod 24 supports the one end of the road 10.

Rotation of the anvil 3 to the desired orientation is sensed or controlled by the motor in a conven-- tional manner. The drum 16 is also rotated by the motor 4 in the same manner so that the slider 20 is orientated to push the anvil 3 in the desired direction. When the anvil is at the correct or intended angle, the air cylinder 22 is activated to depress the one end 24a of the rod 24 causing the anvil 3 to be brought into contact with the leg or lead to be bent. The air cylinder 21 is then activated to cause the rocking member 18 to pivot and push the slider 20, and therefore the anvil 3 in the desired direction. The anvil 3 is automatically returned to the rest position by deactivation of the cylinders 21 and 22, respectively, after a component lead or leg has been bent.

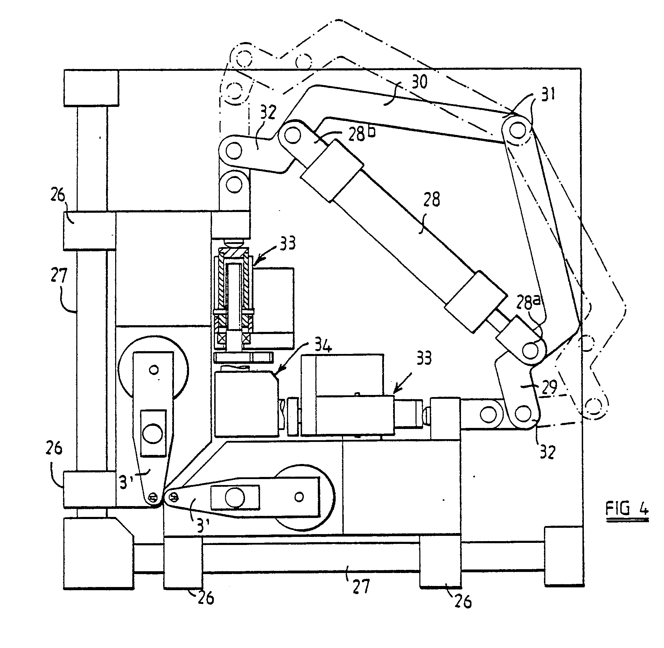

Figure 4 illustrates schematically apparatus comprising two of the bending devices of Figure 3, each bending device being arranged to bend a respective leg of a component each device is carried by respective slides 26 mounted on an associated guide 27.

The slides are movable by a piston and cylinder arrangement 28, one end 28a of which is pivotally connected to an intermediate portion of a first crank arm 29 and the other end 28b of which is pivotally connected to an intermediate portion of a second crank arm 30.

Adjacent ends 31 of the two arms are connected together and the other ends 32 thereof are pivotally connected to respective slides so that actuation of the piston and cylinder arrangement 28 forces the arms 29 and 30 either together or apart controlling relative movement of the slides. Respective shock absorbers 33 are mounted to the slides to prevent damage if the slides contact a block 34 provided to limit movement of the slide.

The arrangement of the piston and cylinder arrangement 28 and the crank arms 29 and 30 shown in solid lines in Figure 4 is the position in which, as shown, the devices 3' are in a working condition to bend the legs of a component inserted in a printed circuit board while the arrangement of the piston and cylinder arrangement 28 and the crank arms 29 and 30 shown in dotted lines illustrates the position thereof when the devices are in a rest position.

Thus, by moving each device along the respective guides 27 which, in the arrangement shown, are mutually perpendicular, all points in an L-shape can be reached, and by appropriate programming all likely component leads positions can be reached using a printed circuit board assembly machine incorporating such apparatus.

**Claims**

1. Apparatus for bending the legs of a component inserted into a printed circuit board, the apparatus comprising a plurality of bending devices, each bending device comprising an engaging member (3) rotatably mounted to a frame (8) of the device for engaging a respective leg (1) of a component, means (4, 5, 6, 7, 9) for rotating the engaging member to a selected one of a plurality of orientations and means (20, 21) for displacing the engaging member in the selected orientation to bend the respective component leg in a selected direction, the means for displacing the engaging member comprising a slider (20) which is connected to the respective engaging member (3) and which is movable by a respective hydraulically actuated device (21) to effect translational movement of the engaging member.

2. Apparatus according to Claim 1, wherein each hydraulically actuated device (21) comprises a pivotally mounted bifurcate (18) member having one arm (18b) engaging the respective slider and a second arm (18a) engaging a piston (17) of the hydraulically actuated device.

3. Apparatus according to Claim 2, wherein each bifurcate member (18) is pivotally mounted to an inner surface of a respective drum (16) which is rotatable about the piston (17) of the respective hydraulically actuated device (21).

4. Apparatus according to Claim 3, wherein each drum (16) is rotatable by a motor (4) via transmission means (5, 11, 12, 13).

5. Apparatus according to any preceding claim, wherein a respective piston and cylinder arrangement (22, 23, 24) is provided to lower or raise each engaging member (3) relative to a component leg (1).

6. Apparatus according to any preceding claim, including means (26, 27, 28, 29, 30) for controlling relative movement of the bending devices.

7. Apparatus according to Claim 6, wherein the controlling means comprises a respective slide (26) each bending device and means (28 and 29 or 30) for controlling movement of each slide on a respective guide means (27) so as to control the relative movement of the device.

**Patentansprüche**

1. Vorrichtung zum Umbiegen der Anschlußdrähte von Komponenten zum Einsetzen in gedruckte Schaltungen mit mehreren Biegeeinrichtungen, die je ein auf einem Rahmen (8) der Einrichtung drehbar angebrachtes Anschlagteil (3) zum Ineingriffkommen mit den Anschlußdrähten (1) der Komponenten, Mittel (4, 5, 6, 7, 9) zum Drehen der Anschlagteile in eine ausgewählte mehrerer Orientierungen und Mittel (20, 21) umfassen zum Ausrichten der Anschlagteile in der ausgewählten Orientierung, um den jeweiligen Komponentenanschlußdraht in einer ausgewählten Richtung umzubiegen, wobei die Mittel zum Ausrichten des Anschlagsteils einen Gleiter (20) umfassen, der mit dem entsprechenden Anschlagteil (3) verbunden und mittels einer hydraulisch betriebenen Einrichtung (21) bewegbar ist, um eine Translationsbewegung des Anschlageils hervorzurufen.

2. Vorrichtung nach Anspruch 1, dadurch gekennzeichnet, daß jede hydraulisch betriebene Einrichtung (21) ein drehbar gelagertes Gabelteil (18) umfaßt, dessen einer Arm (18b) mit dem Gleiter und dessen zweiter Arm (18a) mit dem Kolben (17) der hydraulisch betriebenen Einrichtung in Eingriff steht.

3. Vorrichtung nach Anspruch 2, dadurch gekennzeichnet, daß jedes Gabelteil (18) schwenkbar an der Innenwand einer Trommel (16) angebracht ist, die um einen Kolben (17) der hydraulisch betriebenen Einrichtung (21) drehbar ist.

4. Vorrichtung nach Anspruch 3, dadurch gekennzeichnet, daß jede Trommel (16) mittels eines Motors (4) über Übertragungsmittel (5, 11, 12, 13) drehbar ist.

5. Vorrichtung nach einem der vorangehenden Ansprüche, gekennzeichnet durch eine Kolben-Zylinder-Anordnung (22, 23, 24) zum Absenken oder Anheben jedes Anschlagteils (3) relativ zu einem Komponentenanschlußdraht (1).

6. Vorrichtung nach einem der vorangehenden Ansprüche, gekennzeichnet durch Mittel (26, 27, 28, 29, 30) zum Steuern der Relativbewegung der Umbiegevorrichtungen.

7. Vorrichtung nach Anspruch 6, dadurch gekennzeichnet, daß die Steuermittel die einzelnen Umbiegvorrichtungen tragende Gleiter (26) und Mittel (28, 29 oder 30) zum Steuern der Bewegung eines jeden Gleiters auf entsprechenden Führungsmitteln (27) umfassen, so daß die Relativbewegung der Vorrichtung gesteuert wird.

**Revendications**

1. Appareil pour plier les jambages d'un composant inséré dans un panneau de circuit imprimé, l'appareil comprenant une pluralité de dispositifs de pliage, chaque dispositif de pliage comprenant une pièce d'engagement (3) montée d'une façon rotative dans un cadre (8) du dispositif pour venir en engagement avec un jambage respectif (1) d'un composant, des moyens (4, 5, 6, 7, 9) pour faire tourner la pièce d'engagement jusqu'à une orientation choisie parmi une pluralité d'orientations et des moyens (20, 21) pour déplacer la pièce d'engagement dans l'orientation choisie pour plier respectivement le jambage du composant dans une direction choisie, les moyens pour déplacer la pièce d'engagement comprenant une glissière (20) qui est reliée à la pièce d'engagement respective (3) et qui est rendue mobile grâce respectivement à un dispositif actionné hydrauliquement (21) pour effectuer un mouvement de translation de la pièce d'engagement.

2. Appareil conforme à la revendication 1, dans lequel chaque dispositif actionné hydrauliquement (21) comprend une pièce bifurquée montée pivotante (18) ayant un bras (18b) s'engageant avec la glissière respective et un second bras (18a) s'engageant avec un piston (17) du dispositif actionné hydrauliquement.

3. Appareil conforme à la revendication 2 dans lequel chaque pièce bifurquée (18) est montée pivotante sur la surface intérieure d'un tambour respectif (16) qui peut tourner par rapport au piston (17) du dispositif respectif actionné hydrauliquement (21).

4. Appareil conforme à la revendication 3 dans lequel chaque tambour (16) peut être entraîné en rotation par un moteur (4) par l'intermédiaire de moyens de transmission (5, 11, 12, 13).

5. Appareil conforme à l'une quelconque des revendications précédentes dans lequel un dispositif respectif à piston et cylindre (22, 23, 24) est prévu pour abaisser ou élever chaque pièce d'engagement (3) relative à un jambage de composant (1).

6. Appareil conforme à l'une quelconque des revendications précédentes comprenant des moyens (26, 27, 28, 29, 30) pour commander le mouvement relatif au dispositif de pliage.

7. Appareil conforme à la revendication 6 dans lequel les moyens de commande comprennent une glissière respective (26) portant chaque dispositif de pliage et des moyens (28 et 29 ou 30) pour commander le mouvement de chaque glissière sur des moyens de guidage respectifs (27) de façon à commander le mouvement relatif du dispositif.

FIG. 1

FIG. 2

FIG. 3 A

FIG. 3

2

FIG 4